# EUROPEAN PATENT APPLICATION

(11) **EP 1 727 191 A1**
(43) Date of publication of application: **29.11.2006**
(21) Application number: 05720138.6
(22) Date of filing: 07.03.2005
(51) Int. Cl.: H01L 21/304, H01L 21/306

(54) **SUBSTRATE PROCESSING EQUIPMENT**

(30) Priority: 12.03.2004 JP 2004071006
(71) Applicant: Sipec Corporation, Tokyo 1120012 (JP)
(72) Inventor: ENDO, Tamio, c/o SIPEC CORPORATION, Tokyo 1120012 (JP); OKURA, Ryoichi, c/o SIPEC CORPORATION, Tokyo 1120012 (JP); YOSHIDA, Tatsuro, c/o SIPEC CORPORATION, Tokyo 1120012 (JP); TAKIKAWA, Yoshishige, c/o SIPEC CORPORATION, Tokyo 1120012 (JP)
(74) Representative: Vossius & Partner
(86) International application number: PCT/JP2005/003866
(87) International publication number: WO 2005/088691

(57) **Abstract**

A plurality of liquid chemicals are fed onto a substrate to be treated, which is held and spinned, and the liquid chemicals scattered from the substrate to be treated by a rotator are separately recovered in respective recovery tanks (16 to 19) by each chemical. A lifting mechanism controls lifting operation of respective fences (3a to 3s) which form respective recovery tanks (16 to 19) so as to recover the liquid chemical into a certain recovery tank, while at the time, inlets of the other recovery tanks are closed at that time. Such a lifting mechanism includes a fence lifting plate provided with a cams portions 29a engaging with the respective fences (3a to 3d) to lift the corresponding fence, and performs lifting operation of the respective fences (3a to 3d) by rotating the fence lifting plate (29) around the shaft of the fence lifting plate (29) by a motor (34) so that the liquid chemical to be recovered is prevented from mixing in other recovery tanks.

## Description

### Technical Field

The present invention relates to a substrate treatment apparatus, especially suitable for use in separated recovery of various treatment liquids after treatment of the substrate.

### Background Art

Conventionally, in various manufacturing processes to form a semiconductor device or the like on a substrate, a sheet-fed type substrate treatment apparatus to perform liquid chemical treatment such as wet etching, wet cleaning, or the like by individual substrate has been used. The substrate treatment apparatus is used to perform various treatment on the substrate by feeding various liquid chemicals while spinning the substrate which is fixedly positioned, and the liquid chemicals used to treat the substrate are scattered from the substrate by a rotational centrifugal force and recovered into a recovery tank provided on the substrate side and discharged. At this time, the liquid chemicals scattered from the substrate are mixed with the circumabient atmosphere and collected in a mist or gaseous state into the recovery tank.

When recovering the liquid chemicals used for treating the substrate in the conventional substrate treatment, acidic liquid chemicals and alkaline liquid chemicals are mixed to produce salts by chemical reaction, which results in particle generation. In order to avoid the problem, treatment with acidic liquid chemicals and that with alkaline liquid chemicals are performed in separate substrate treatment apparatuses.

The aforementioned recovery method of the liquid chemicals will be explained here referring to Patent Document 1 shown below as an example of the conventional substrate treatment apparatus.

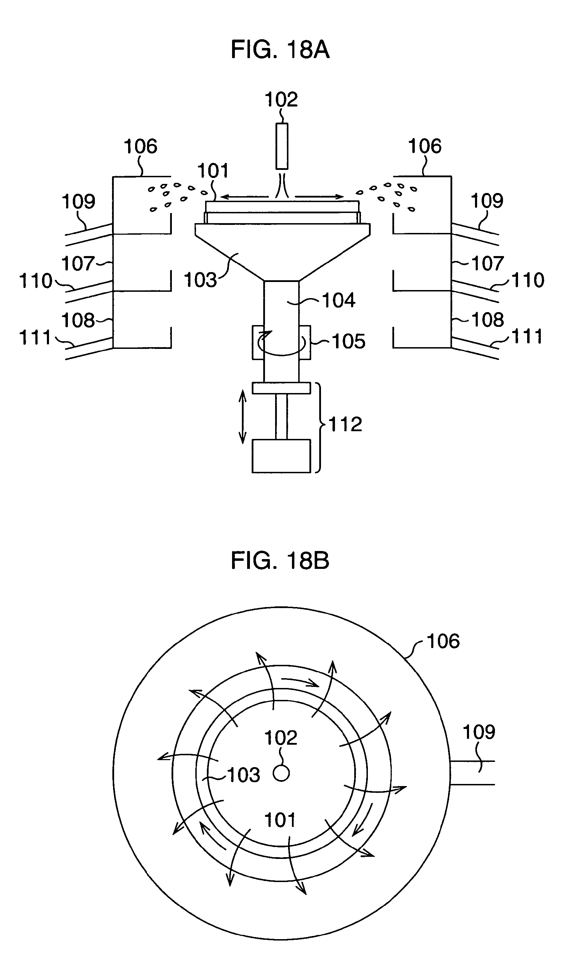

Figs. 18A and 18B are schematic diagrams of a substrate treatment apparatus as an conventional example, showing the cross section thereof in Fig. 18A and the top view thereof in Fig. 18B.

As shown in Fig. 18A and Fig. 18B, 101 is a substrate to be treated, 102 is a liquid chemical feed nozzle to supply various liquid chemicals to the substrate 101, 103 is a substrate chucking unit to hold the substrate 101, 104 is a shaft connected to the substrate chucking unit 103, 105 is a motor spinning the substrate 101 held by the substrate chucking unit 103 around the axial direction of the shaft 104, 106 to 108 are recovery pots provided for collecting the liquid chemicals by respective chemicals, 109 to 111 are liquid disposal mechanisms provided in respective recovery pots 106 to 108, and 112 is a lifting device to vertically adjust the height of the substrate chucking unit 103.

The substrate treatment apparatus shown in the conventional example performs treatment of the substrate 101 by holding the substrate 101 with the substrate chucking unit 103, and feeding the liquid chemicals on the substrate 101 from the liquid chemical feed nozzle 102 while spinning the substrate 101 around the axis of the shaft 104 by driving the motor 105. The liquid chemicals scattered from the substrate 101 by the spinning of the motor 105 are recovered in the recovery pot 106. The recovered liquid chemicals are discharged from the liquid discharging mechanism 109.

Then, the substrate 101 is moved to the position of the inlet of the recovery pot 107 by driving the lifting device 112. Another liquid chemical is fed onto the substrate 101 from the liquid chemical feed nozzle 102 while spinning the substrate 101 with the motor 105 to treat the substrate 101 and the liquid chemical is recovered after the treatment into the recovery pot 107. Then, the substrate 101 is moved to the position of the inlet of the recovery pot 108 by driving the lifting device 112 and the substrate 101 is treated with still another liquid chemical in the above-described manner, and the liquid chemical is collected after the treatment into the recovery pot 108. Here, the various liquid chemicals used to treat the substrate 101 and collected in the recovery pots 106 to 108 are mixed with the circumambient atmosphere and collected in a mist or gaseous state. Following this process, a plurality of liquid chemicals used to treat the substrate 101 are recovered separately.

Patent Document 1:Japanese Patent Application Laid-open No. Hei 5-283395

### Summary of the Invention.

However, since recovery of the liquid chemicals is performed in a state that the openings of other recovery pots are opened in the above-described conventional substrate treatment apparatus, there has been the fear that liquid chemicals in a mist or gaseous state after the substrate treatment might mix into other recovery pots. Especially when treatment with acidic liquid chemicals and treatment with alkaline liquid chemicals are performed, this causes a remarkable problem because it brings generation of particles described above. In order to prevent such mixing of the liquid chemicals, for instance, it is necessary to concurrently use a plurality of substrate treatment apparatuses for treatment involving acidic and alkaline liquid chemicals. However, since this requires a plurality of substrate treatment apparatuses, it further complicates the process.

In recent years, along with the high integration of semiconductor substrates or the like, the sophistication of manufacturing devices has progressed, and the apparatus configuration of the manufacturing devices has increased more and more in complexity. Therefore, for the substrate treatment apparatus to feed various liquid chemicals on a substrate to be treated and to recover the liquid chemicals used to treat the substrate to be treated, preparation of the apparatus configuration is required to be as simple as possible.

The present invention has been made in view of the above problems and an object thereof is to provide a substrate treatment apparatus which reliably prevents mixing of the liquids used for the treatment in successive steps using the same apparatus configuration, when these treatment liquids are recovered after their respective treatments have been performed on the substrate in high reliability with a simple configuration.

A substrate treatment apparatus of the present invention includes a substrate holder holding a substrate to be treated, a substrate rotator spinning the substrate to be treated held by the substrate holder, a treatment liquid feeder feeding a plurality of treatment liquids on the substrate to be treated, and a treatment liquid recovery system including a plurality of fences surrounding the periphery of the substrate to be treated held by the substrate holder, separately recovering the treatment liquids scattered from the substrate to be treated by the substrate rotator into respective recovery tanks formed by the respective fences by chemicals by lifting the respective fences, and performing the recovery in a closed state of the inlets of the other recovery tanks when the treatment liquids are recovered in one of the recovery tank, in which the treatment liquid recovery system includes a fence lifting plate provided with cams lifting the fences by engaging with the respective fences and performs the lifting operation of the respective fences by rotating the fence lifting plate in a plane forming the cam of the fence lifting plate.

In another embodiment of the substrate treatment apparatus in the present invention, the fence lifting plate is provided with the cam corresponding to each of the respective fences.

In still another embodiment of the substrate treatment apparatus in the present invention, the cam is a protrusion formed on the surface of the fence lifting plate, and the treatment liquid recovery system forms guide channels for the recovery tanks recovering the treatment liquids by rotating the fence lifting plate within a plane forming the cam of the fence lifting plate so as to hoist the fence by moving the fence onto the upper surface of the protrusion.

In yet another embodiment of the substrate treatment apparatus of the present invention, the respective fences are arranged layered one by one from the side closest to the substrate to be treated so as to close the inlets of the respective recovery tanks, and the treatment liquid recovery system starts recovery operation from the recovery tank at the farthest position away from the substrate to be treated.

### Brief Description of the Drawings

Fig. 1 is a schematic cross-sectional view of a substrate treatment apparatus relating to an embodiment of the present invention;
Fig. 2 is a schematic cross-sectional view of a lifting mechanism in the substrate treatment apparatus of the present embodiment;
Fig. 3 is a top view of the fence lifting plate shown in Fig. 2;
Fig. 4 is a cross-sectional view of respective cam charts shown in Fig. 3;
Fig. 5 is a cross-sectional view of the substrate treatment apparatus of the present embodiment seen from above;
Fig. 6 is a schematic cross-sectional view showing the tip portions of the respective fences forming recovery tanks;
Fig. 7 is a schematic cross-sectional view showing the tip portions of the respective fences forming the recovery tanks;
Fig. 8 is a schematic cross-sectional view before recovery of liquid chemicals in the substrate treatment apparatus of the present embodiment;
Fig. 9A is a cross-sectional view of the lifting mechanism of the substrate treatment apparatus shown in Fig. 8;
Fig. 9B is a top view of the respective cam charts of fence lifting plates of the substrate treatment apparatus shown in Fig. 8;
Fig. 10 is a schematic cross-sectional view showing recovery steps of liquid chemicals in the substrate treatment apparatus of the present embodiment, continued from Fig. 8;
Fig. 11A is a cross-sectional view of the lifting mechanism of the substrate treatment apparatus shown in Fig. 10;
Fig. 11B is a top view of the respective cam charts of the fence lifting plates of the substrate treatment apparatus shown in Fig. 10;
Fig. 12 is a schematic cross-sectional view showing recovery steps of liquid chemicals in the substrate treatment apparatus of the present embodiment, continued from Fig. 10;
Fig. 13A is a cross-sectional view of the lifting mechanism of the substrate treatment apparatus shown in Fig. 12;
Fig. 13B is a top view of the respective cam charts of the fence lifting plates of the substrate treatment apparatus shown in Fig. 12;
Fig. 14 is a schematic cross-sectional view showing recovery steps of liquid chemicals in the substrate treatment apparatus of the present embodiment, continued from Fig. 12;
Fig. 15A is a cross-sectional view of the lifting mechanism of the substrate treatment apparatus shown in Fig. 14;
Fig. 15B is a top view of the respective cam charts of the fence lifting plates of the substrate treatment apparatus shown in Fig. 14;
Fig. 16 is a schematic cross-sectional view showing recovery steps of liquid chemicals in the substrate treatment apparatus of the present embodiment, continued from Fig. 14;
Fig. 17A is a cross-sectional view of the lifting mechanism of the substrate treatment apparatus shown in Fig. 16;
Fig. 17B is a top view of the respective cam charts of the fence lifting plates of the substrate treatment apparatus shown in Fig. 16;
Fig. 18A is a schematic cross-sectional view of a substrate treatment apparatus of a conventional example; and
Fig. 18B is a schematic top view of the substrate treatment apparatus of the conventional example.

### Detailed Description of the Preferred Embodiments

A concrete embodiment of a substrate treatment apparatus of the present invention and the method of the treatment will be explained hereinafter referring to the attached drawings.

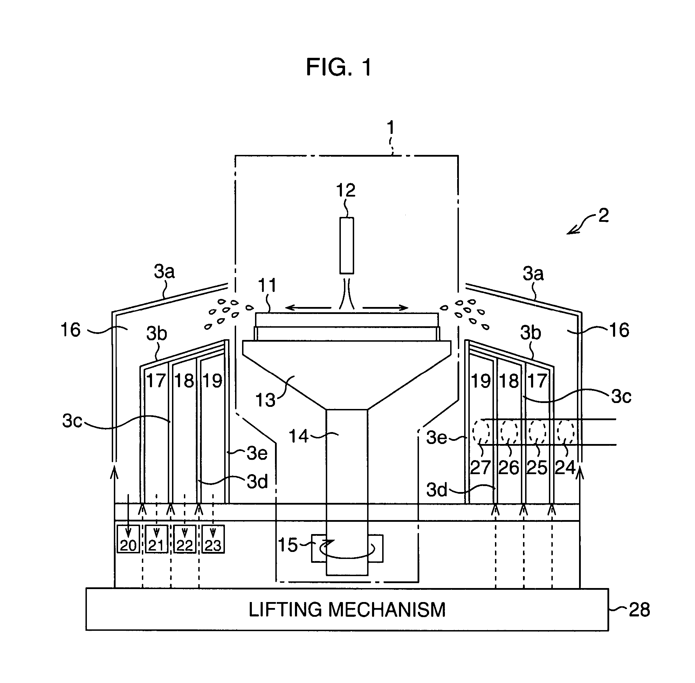

Fig. 1 is a schematic cross-sectional view of a substrate treatment apparatus relating to an embodiment of the present invention.
As shown in Fig. 1, the substrate treatment apparatus includes a substrate treatment unit 1 installed with a substrate 11 to be treated and performing treatment of the substrate 11 on the surface using various treatment liquids (liquid chemicals), and a liquid chemical recovery unit 2 which separately recovers various liquid chemicals used for the treatment.

In the substrate treatment unit 1, 12 is a liquid chemical feed nozzle feeding various liquid chemicals to the substrate 11, 13 is a substrate chucking unit holding the substrate 11, 14 is a shaft connected to the substrate chucking unit 13, and 15 is a motor to spin the substrate 11 held by the substrate chucking unit 13 around the axial of the shaft 14.

In the liquid chemical recovery unit 2, 16 to 19 are recovery tanks formed by the respective fences 3a to 3d and a parting plate 3e to recover the liquid chemicals by each chemical, 20 to 23 are liquid discharge mechanisms provided to the respective recovery tanks 16 to 19, 24 to 27 are exhaust mechanism respectively provided to the respective recovery tanks 16 to 19, and 28 is a lifting mechanism which forms guide channels of the respective recovery tanks 16 to 19 by driving vertically the fences 3a to 3d forming the respective recovery tanks 16 to 19. Here, the recovery tank 16 is formed by the fences 3a and 3b, the recovery tank 17 is formed by the fences 3b and 3c, the recovery tank 18 is formed by the fences 3c and 3d, and the recovery tank 19 is formed by the fence 3d and the parting plate 3e. The respective fences 3a to 3d are provided with cleaning mechanisms, though not shown, to clean inside them with pure water or the like, and are constructed with materials excellent in chemical resistance and water absorption resistance such as Teflon (R).

The lifting mechanism 28 will be explained in detail next.

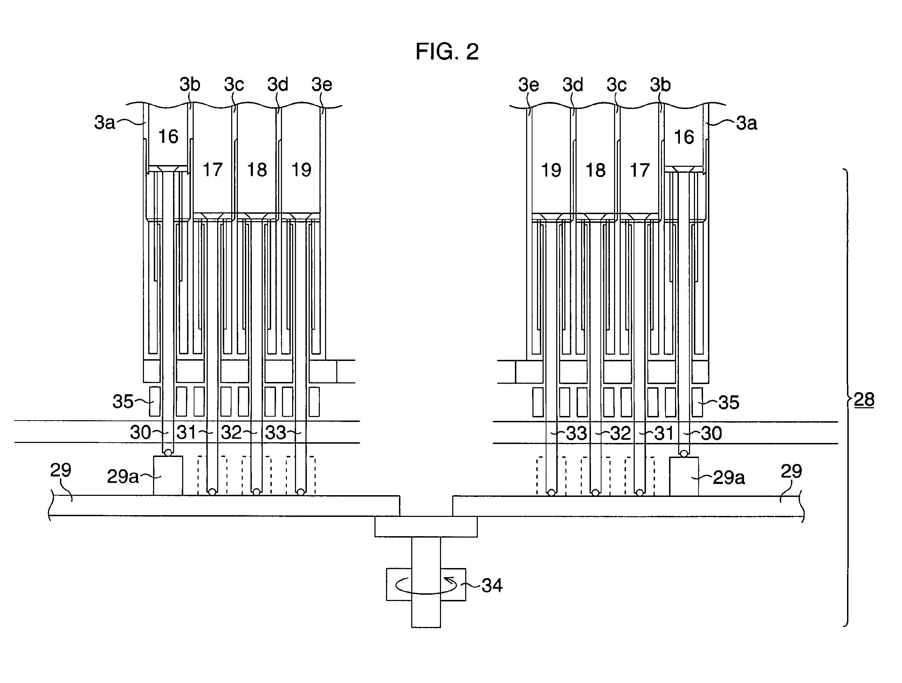

Fig. 2 is a schematic cross-sectional view of the lifting mechanism 28 in the substrate treatment apparatus of the present embodiment. Fig. 2 shows drive movement of the lifting mechanism 28 at the time of performing recovery of liquid chemicals in the recovery tank 16 while hoisting the fence 3a shown in Fig. 1.

As shown in Fig. 2, the lifting mechanism 28 includes respective shafts 30 to 33 connected to the respective fences 3a to 3d, a fence lifting plate 29 on which cams (portions with difference in level) 29a engaging with the respective shafts 30 to 33, and a motor 34 spinning the fence lifting plate 29 around the axis of the fence lifting plate 29. Guides 35 are provided on the side of the respective shafts 30 to 33 to position the respective shafts 30 to 33, and are structured with, for instance, fluorine contained resin, or metal such as stainless steel or the like when no contact with liquid chemicals is expected.

In the substrate treatment apparatus of the present embodiment, the guide channels of the respective recovery tanks 16 to 19 are formed by hoisting the respective fences 3a to 3d by spinning the fence lifting plate 29 around the axis of the fence lifting plate 29 with the motor 34 and by engaging the respective shafts 30 to 33 connected to the respective fences 3a to 3d with the cams 29a, so that various liquid chemicals are recovered in the recovery tanks in which the guide channels are formed.

The fence lifting plate 29 will be explained in detail here.

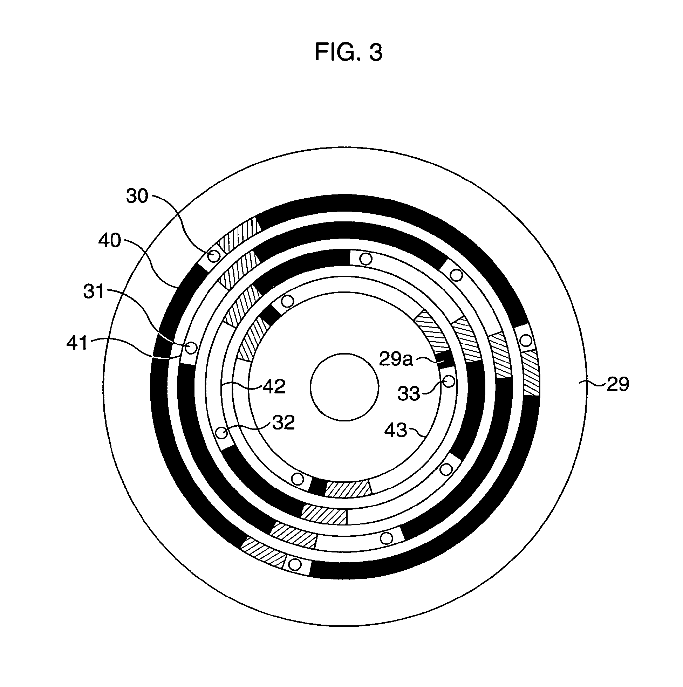

Fig. 3 is a top view of the fence lifting plate 29 shown in Fig. 2. Here in Fig. 3, the positions marked by 0 are those where the respective shafts 30 to 33 connected to the respective fences 3a to 3d are arranged. In the present embodiment, three of the respective shafts 30 to 33 are connected to the respective fences 3a to 3d. Further in the fence lifting plate 29, respective cam charts 40 to 43 are formed in correspondence with the fences 3a to 3d respectively.

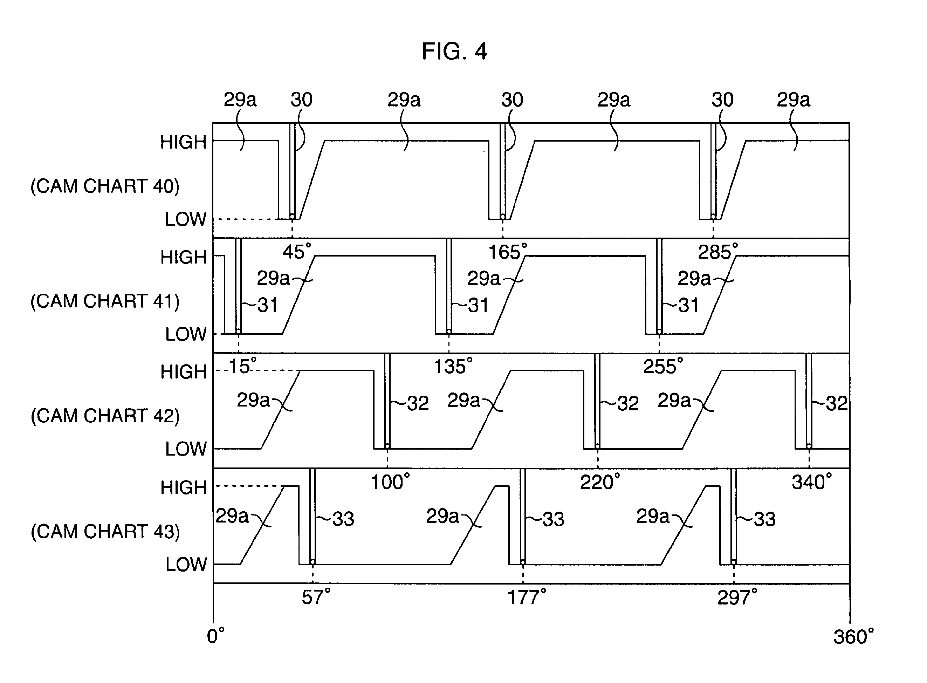

Fig. 4 is a cross-sectional view of the respective cam charts 40 to 43 shown in Fig. 3. The positions where the respective shafts 30 to 33 connected to the respective fences 3a to 3d are arranged are also shown in Fig. 4.

As clear from Fig. 4, the cams 29a are structured by forming protrusions on the surface of fence lifting plates, and surfaces to hoist the respective shafts 30 to 33 connected to the respective fences 3a to 3d to the upper surfaces of the protrusions (surfaces shown with [high] in Fig. 4) are formed in a gentle slope, and surfaces to lower the respective shafts 30 to 33 from the upper surfaces are formed in a steep slope or in a vertical surface. In the present embodiment, the gentle slopes of the cams 29a are formed at an angle of about 30 in all the cams of the respective cam charts 40 to 43. The reason for forming the surfaces to lower the respective shafts 30 to 33 from the upper surfaces of the cams 29a with a steep slope or a vertical surface is to be able to lower the respective fences 3a to 3d quickly.

The regions shown in black in the respective cam charts 40 to 43 in Fig. 3 are those showing the upper surfaces of the protrusions of the cams 29a shown in Fig. 4. The regions shown by diagonal lines in the respective cam charts 40 to 43 in Fig. 3 are those of the above-described gentle slopes of the cams 29a shown in Fig. 4. The regions shown in white in the respective cam charts 40 to 43 in Fig. 3 are those where no cams 29a shown in Fig. 4 are formed (surfaces shown with [low] in Fig. 4).

The setting condition of the fences 3a to 3d forming the recovery tanks 16 to 19 will be explained next.

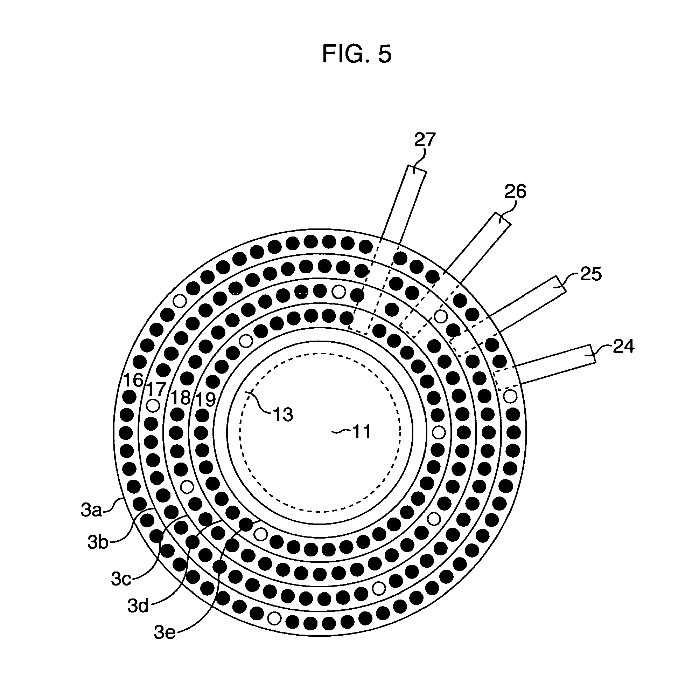

Fig. 5 is a cross-sectional view in the substrate treatment apparatus of the present embodiment seen from above.
The present embodiment shows the case of four baths of recovery tanks. The recovery tanks 16 to 19 are formed partitioned by the circular fences 3a to 3d so as to surround the circumference of the substrate 11, and the respective shafts 30 to 33 are arranged on the bottom surfaces of the fences at three positions (marked by O) per recovery tank from the baths 16 to 19. Discharge ports are provided at portions marked by • shown in Fig. 5 so that recovered liquid chemicals can be discharged from these discharge ports. Still more, 24 to 27 shown in Fig. 3 are exhaust mechanisms provided in the respective recovery tanks 16 to 19 to exhaust collected gases.

Inlet portions of the recovery tanks 16 to 19 will be explained in detail next.

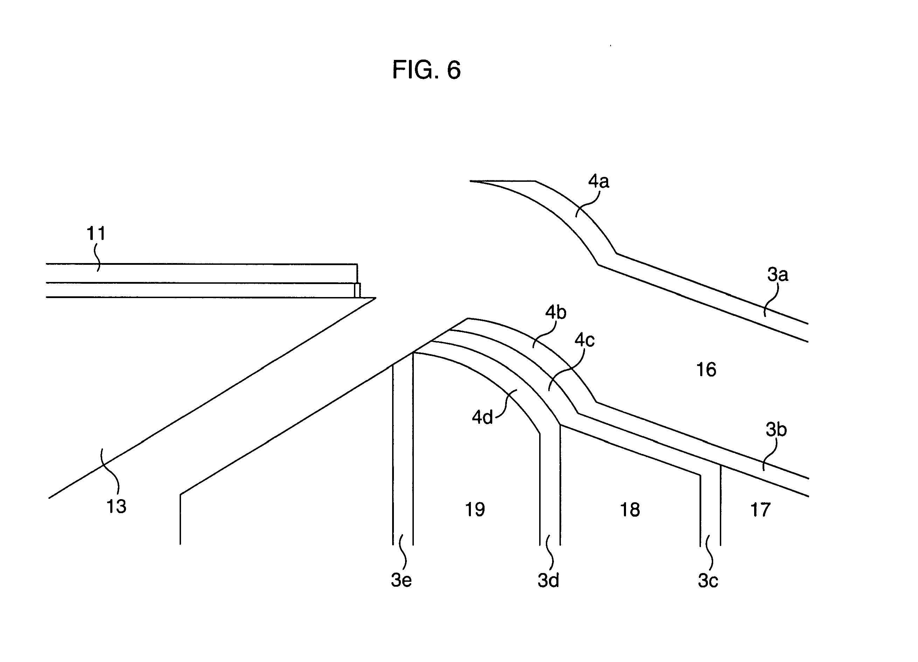

Fig. 6 is a schematic cross-sectional view showing tip portions of the respective fences 3a to 3d forming the recovery tanks 16 to 19. The state shown in Fig. 6 is a cross-sectional view showing a manner when liquid chemicals are applied on the substrate 11 from a liquid chemicals feeder and the liquid chemicals used to treat the substrate 11 are recovered in the outermost side recovery tank 16. At this time, the inlet for only the recovery tank 16 is opened and all inlets of other recovery tanks 17 to 19 are closed.

As shown in Fig. 6, the tip portions 4a to 4d of the fences 3a to 3d have curved structures so that the respective recovery tanks 16 to 19 can be in a closed state only by layering the fences 3a to 3d on each other. Furthermore, the tip portions 4a to 4d are shaped so as to not accumulate liquid chemicals even when the tip portions come to contact with the liquid chemicals. Still further, the tip portions have a shape not to reflect the liquid chemicals to the outside of the recovery tanks 16 to 19. Furthermore, it has a tip shape to let the liquid chemicals fall down outside the recovery tank 16 through the tip portions 4b to 4d, when, for instance, the liquid chemicals which hit on the tip portion 4a fall at a tip portion of the curved tip portion 4b of the fence 3b positioned below.

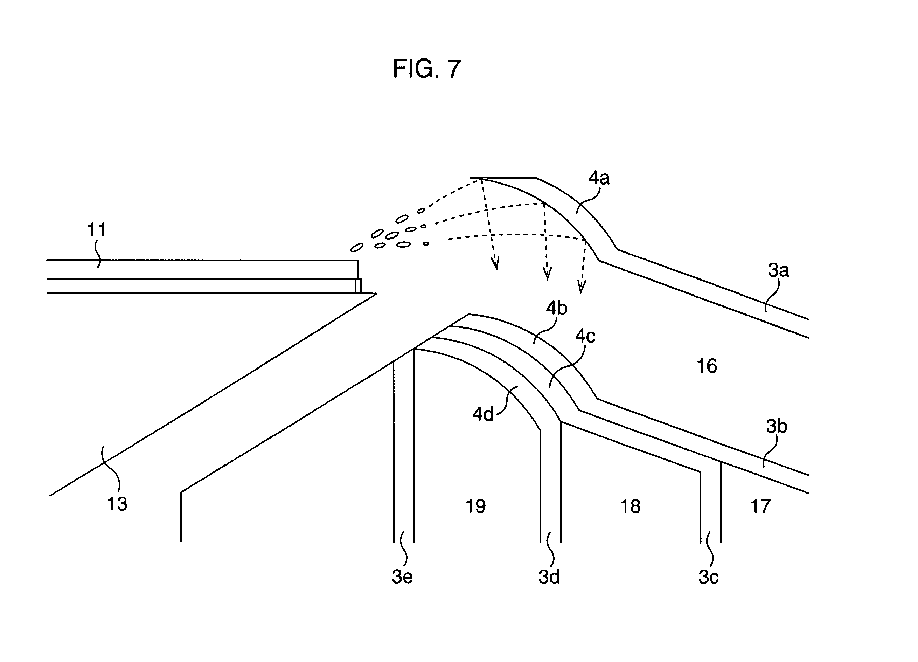

The tip portions 4a to 4d are not required to be sealed with packings or the like, and stacking of the fences 3a to 3d makes the pressure inside the recovery tanks negative so as to be airtight, so that liquid chemicals are not mixed when the liquid chemicals are recovered into other recovery tanks.
At this time, as shown in Fig. 7, the tip portions 4a to 4d are designed with such a degree of curvature that the liquid chemicals are deflected into any one of the recovery tanks 16 to 19 - into the recovery tank 16 in this figure example - without scattering outside of the recovery tank 16, even when the liquid chemicals scattered from the surface of the substrate 11 hit on any one of the tip portions 4a to 4d, - on the tip portion 4a in this figure example. Therefore, each liquid chemical can be reliably recovered into only its corresponding recovery tank.

The step to recover the liquid chemicals used to treat the substrate with the substrate treatment apparatus of the present embodiment will be explained next.

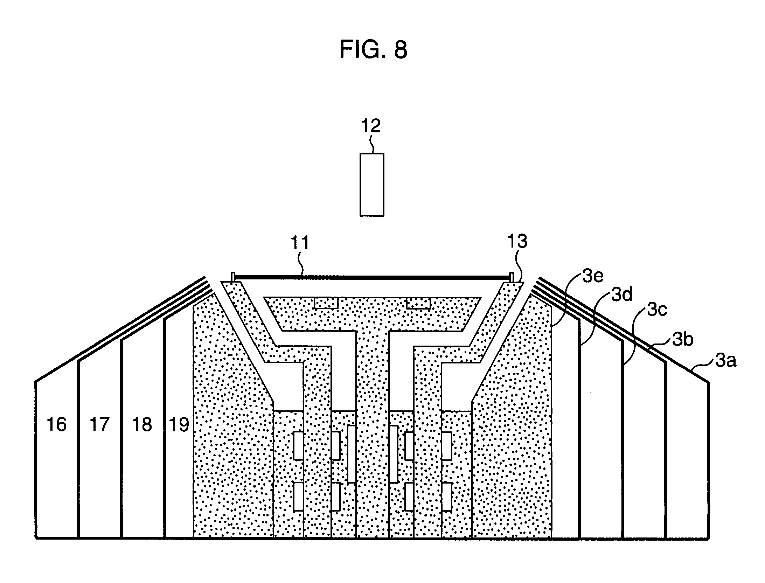

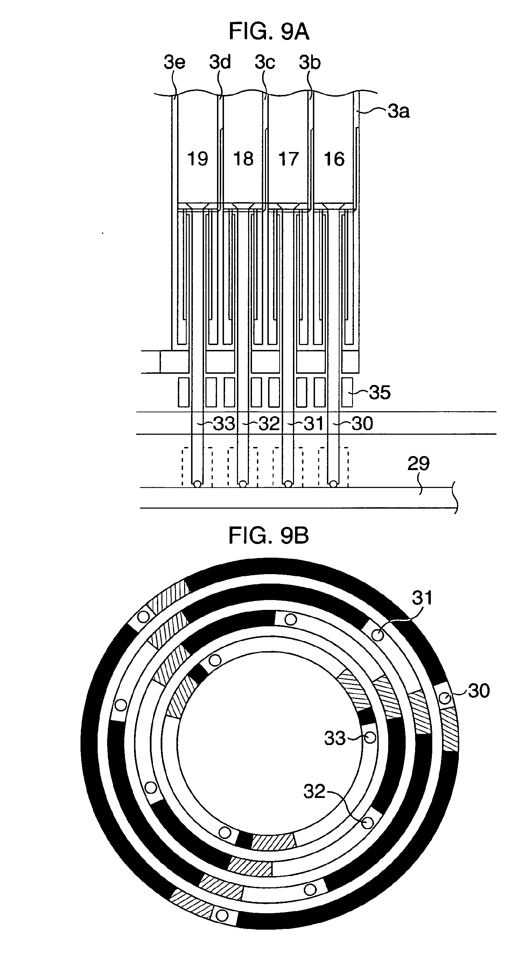

Fig. 8, Fig. 10, Fig. 12, Fig. 14, and Fig. 16 are schematic cross-sectional views showing the steps of recovering the liquid chemicals in the substrate treatment apparatus of the present embodiment. Fig. 9A, Fig. 11A, Fig. 13A, Fig. 15A, and Fig. 17A are cross-sectional views showing movements of the lifting mechanism 28 in the respective steps of the liquid chemical recovery in the substrate treatment apparatus of the present embodiment. Fig. 9B, Fig. 11B, Fig. 13B, Fig. 15B, and Fig. 17B are top views of the respective cam charts of the fence lifting plate 29 in the respective steps of the liquid chemicals recovery in the substrate treatment apparatus of the present embodiment. In the present embodiment, explanation will be made for an example to recover four types of liquid chemicals in four recovery tanks 16 to 19 formed by four fences 3a to 3d and the parting plate 3e disposed to surround the circumference of the substrate 11, but the present invention is not limited to this, and it is possible to structure, for instance, five or more recovery tanks by further increasing the number of fences.

First, Fig. 8 is a schematic cross-sectional view of the substrate treatment apparatus of the present embodiment before recovery of liquid chemicals. Figs. 9A and 9B are schematic diagrams showing movement of the lifting mechanism 28 of the substrate treatment apparatus shown in Fig. 8, in which Fig. 9A shows a cross-sectional view of the lifting mechanism 28 (a right-half cross-sectional view in Fig. 2), and Fig. 9B shows a top view of the respective cam charts of the fence lifting plate 29 (the respective cam charts in Fig. 3).

As shown in Fig. 8, before various liquid chemicals are fed from the liquid chemical feed nozzle 12, the respective fences 3a to 3d are disposed to be layered one by one from the closest side of the substrate 11 so as to close the inlets of the respective recovery tanks 16 to 19, and no fence is driven upward. At this time, in the lifting mechanism 28, as shown in Fig. 9A, the respective shafts 30 to 33 connected to the respective fences 3a to 3d do not engage with the cams 29a of the fence lifting plate 29. The positional relation between the respective shafts 30 to 33 and the cams 29a (between regions shown in black and regions shown by diagonal lines) is as shown in Fig. 9B.

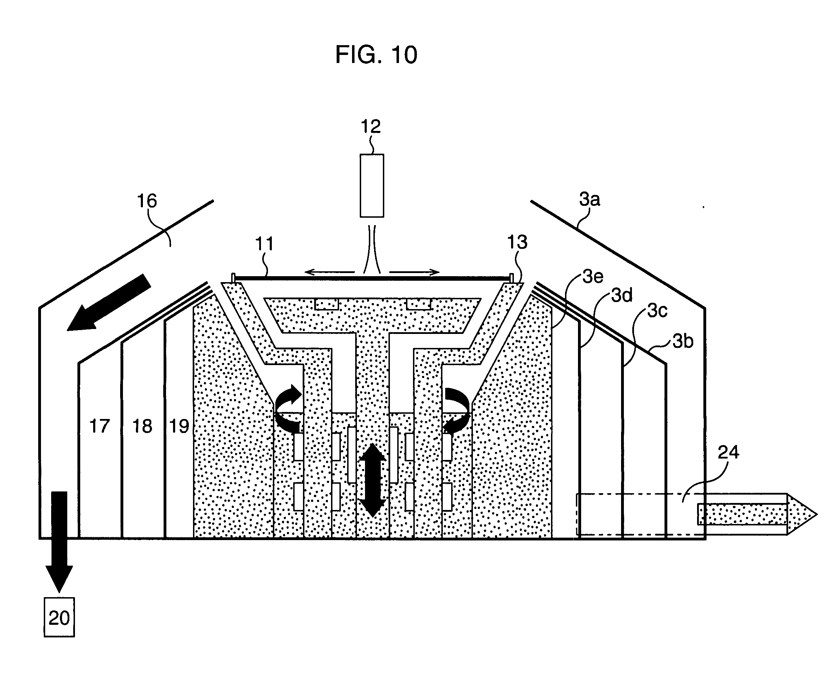

Then, as shown in Fig. 10, before feeding a first liquid chemical from the liquid chemical feed nozzle 12, the inlet of the recovery tank 16 is kept open by upward driving the fence 3a forming the recovery tank 16 by the lifting mechanism 28. At this time, the inlets of the other recovery tanks 17 to 19 are closed.

In this state, the substrate 11 is treated by feeding the first liquid chemical from the liquid chemical feed nozzle 12 while rotating the substrate 11 held by the substrate chucking unit 13 with the motor 15. The first liquid chemical used to treat the substrate 11 is scattered from the substrate 11 due to spinning of the motor 15, and recovered into the recovery tank 16. At this time, the first liquid chemical scattered from the substrate by a rotational centrifugal force is mixed with the circumferential atmosphere and recovered in a mist or gaseous state into the recovery tank 16. The first liquid chemical recovered into the recovery tank 16 is discharged from a liquid discharge mechanism 20 and the recovered gas is discharged from an exhaust mechanism 24.

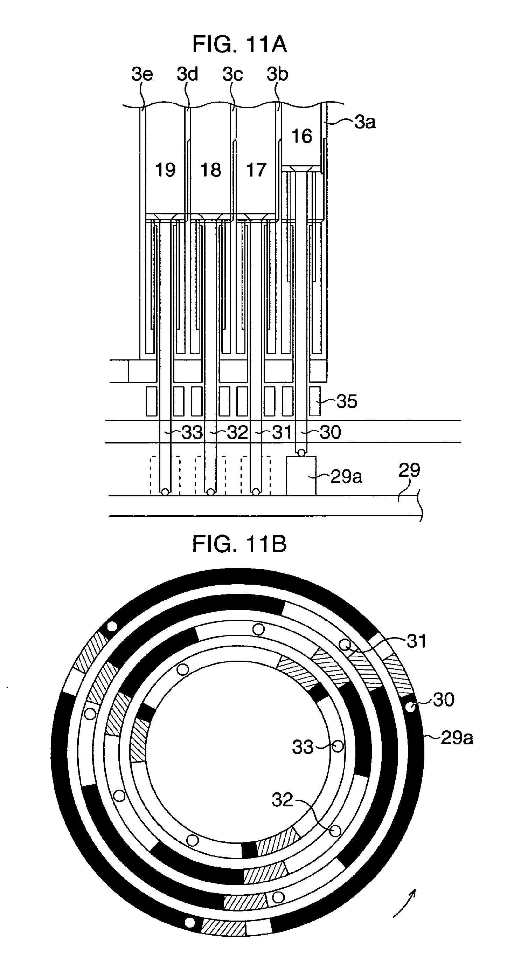

At this time, the lifting mechanism 28 spins the fence lifting plate 29 around the axis of the fence lifting plate 29 by driving the motor 34 shown in Fig. 2. In the present embodiment, the fence lifting plate 29 is rotated by about 21° counterclockwise to the position shown in Fig. 9A. Thereby engaging the shaft 30 disposed at a specific position with the cam 29a of the fence lifting plate 29 which is rotationally moved so as to drive the fence 3a connected to the shaft 30 upward as shown in Fig. 11A. The positional relation between the respective shafts 30 to 33 and the cams 29a (between regions shown in black and regions shown by diagonal lines) is as shown in Fig. 11B. As clearly shown even in Fig. 11B, only the outermost peripheral shaft 30 engages with the cam 29a, and the other shafts 31 to 33 do not engage with the cams 29a (region shown in white).

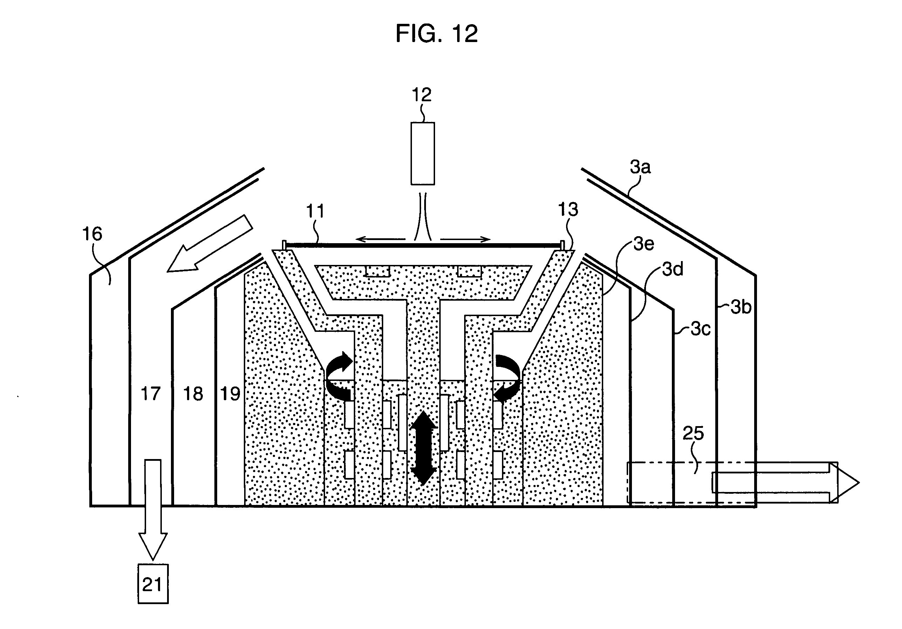

Then, as shown in Fig. 12, before feeding a second liquid chemical from the liquid chemical feed nozzle 12, the fence 3b forming the recovery tank 17 by the lifting mechanism 28 is moved upward to the position to open the inlet of the recovery tank 17 and at the same time to close the inlet of the recovery tank 16. At this time, since the inlets of the recovery tanks 18 and 19 are kept closed, only the inlet of the recovery tank 17 is kept open.

While the substrate 11 is spinned by the motor 15 in this state, the second liquid chemical is fed from the liquid chemical feed nozzle 12 to treat the substrate 11. The second liquid chemical used to treat the substrate 11 is scattered from the substrate 11 by the rotation of the motor 15, and is recovered into the recovery tank 17. At this time, the second liquid chemical scattered from the substrate by a rotational centrifugal force is mixed with the circumferential atmosphere and recovered in a mist or gaseous state into the recovery tank 17. The second liquid chemical recovered into the recovery tank 17 is discharged from a liquid discharge mechanism 21 and the recovered gas is discharged from an exhaust mechanism 25.

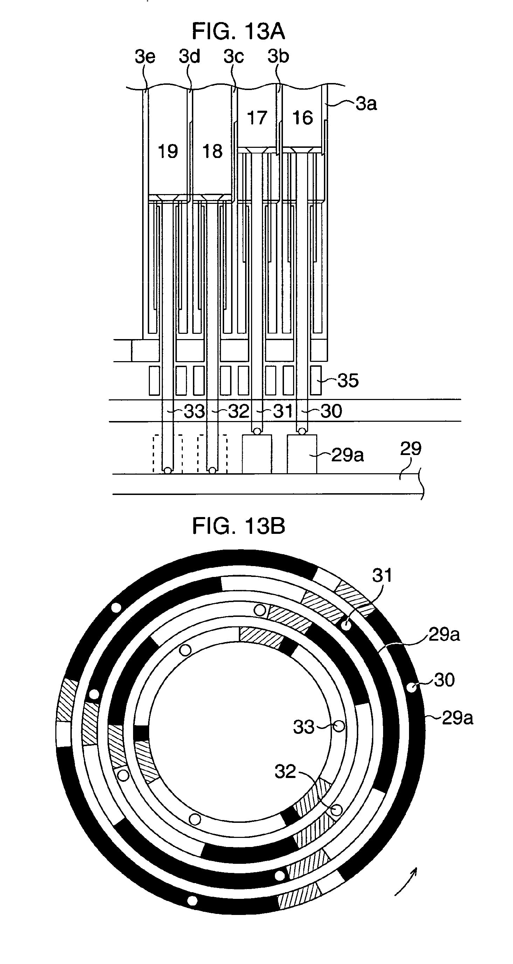

At this time, the lifting mechanism 28 rotates the fence lifting plate 29 further around the axis of the fence lifting plate 29 by driving the motor 34 shown in Fig. 2. In the present embodiment, the fence lifting plate 29 is rotated by about 45° counterclockwise from the position shown in Fig. 9A. Thereby engaging the shafts 30 and 31 disposed at specific positions with the cams 29a of the fence lifting plate 29 which rotationally moved so as to drive the fences 3a and 3b connected to the shafts 30 and 31 upward as shown in Fig. 13A. The positional relation between the respective shafts 30 to 33 and the cams 29a (between regions shown in black and regions shown by diagonal lines) is as shown in Fig. 13B. As clearly shown also in Fig. 13B, the shafts 30 and 31 engage with the cams 29a, and the other shafts 32 and 33 do not engage with the cams 29a (regions shown in white).

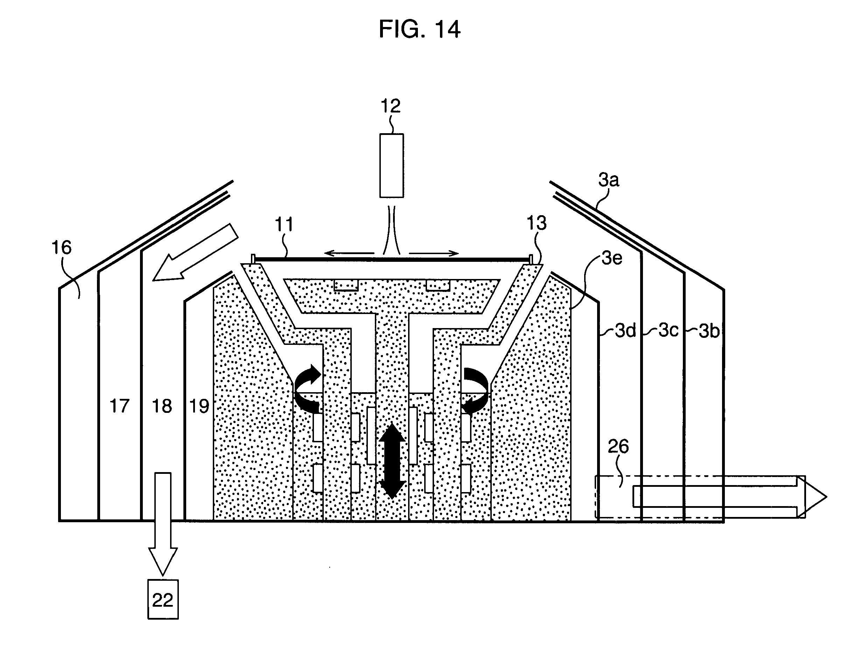

Then, as shown in Fig. 14, before feeding a third liquid chemical from the liquid chemical feed nozzle 12, the fence 3c forming the recovery tank 18 by the lifting mechanism 28 is moved upward to the position to open the inlet of the recovery tank 18 and at the same time to close the inlet of the recovery tank 17. At this time, since the inlets of the recovery tanks 16 and 19 are kept closed, only the inlet of the recovery tank 18 is kept open.

While the substrate 11 is spinned with the motor 15 in this state, the third liquid chemical is fed from the liquid chemical feed nozzle 12 to treat the substrate 11. The third liquid chemical used to treat the substrate 11 is scattered from the substrate 11 due to rotation of the motor 15, and is recovered into the recovery tank 18. At this time, the third liquid chemical scattered from the substrate due to a rotational centrifugal force is mixed with the circumferential atmosphere and recovered in a mist or gaseous state into the recovery tank 18. The third liquid chemical recovered into the recovery tank 18 is discharged from a liquid discharge mechanism 22 and the recovered gas is discharged from an exhaust mechanism 26.

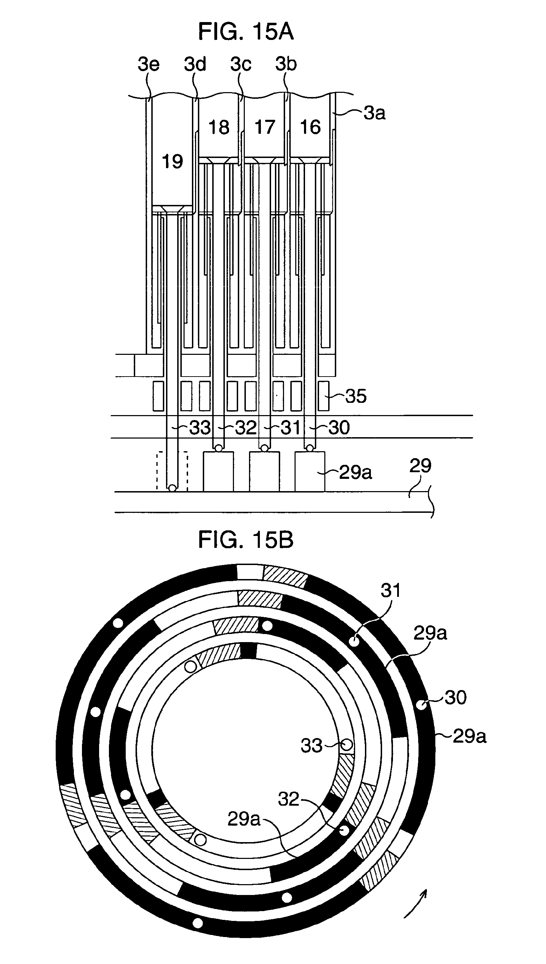

At this time, the lifting mechanism 28 rotates the fence lifting plate 29 further around the axis of the fence lifting plate 29 by driving the motor 34 shown in Fig. 2. In the present embodiment, the fence lifting plate 29 is rotated by about 73° counterclockwise to the position shown in Fig. 9A. Thereby engaging the shafts 30 to 32 disposed at specific positions with the cams 29a of the fence lifting plate 29 which rotationally moved so as to drive the fences 3a to 3c connected to the shafts 30 to 32 upward as shown in Fig. 15A. The positional relation between the respective shafts 30 to 33 and the cams 29a (between regions shown in black and regions shown by diagonal lines) is as shown in Fig. 15B. As clearly shown also in Fig. 15B, the shafts 30 to 32 engage with the cams 29a, and the other shaft 33 does not engage with the cam 29a (region shown in white).

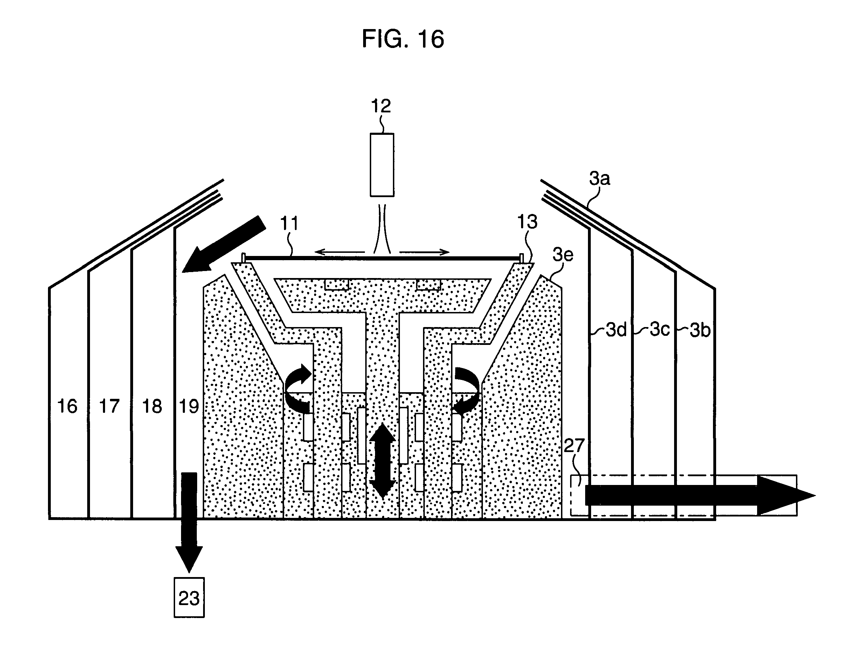

Then, as shown in Fig. 16, before feeding a fourth liquid chemical from the liquid chemical feed nozzle 12, the fence 3d forming the recovery tank 19 with the lifting mechanism 28 is moved upward to the position to open the inlet of the recovery tank 19 and at the same time to close the inlet of the recovery tank 18. At this time, since the inlets of the recovery tanks 16 and 17 are kept closed, only the inlet of the recovery tank 19 is kept open.

While the substrate 11 is spinned with the motor 15 in this state, the fourth liquid chemical is fed from the liquid chemical feed nozzle 12 to treat the substrate 11. The fourth liquid chemical used to treat the substrate 11 is scattered from the substrate 11 due to rotation of the motor 15, and is recovered into the recovery tank 19. At this time, the fourth liquid chemical scattered from the substrate due to a rotational centrifugal force is mixed with the circumferential atmosphere and recovered in a mist or gaseous state into the recovery tank 19. The fourth liquid chemical recovered into the recovery tank 19 is discharged from a liquid discharge mechanism 23 and the recovered gas is discharged from an exhaust mechanism 27.

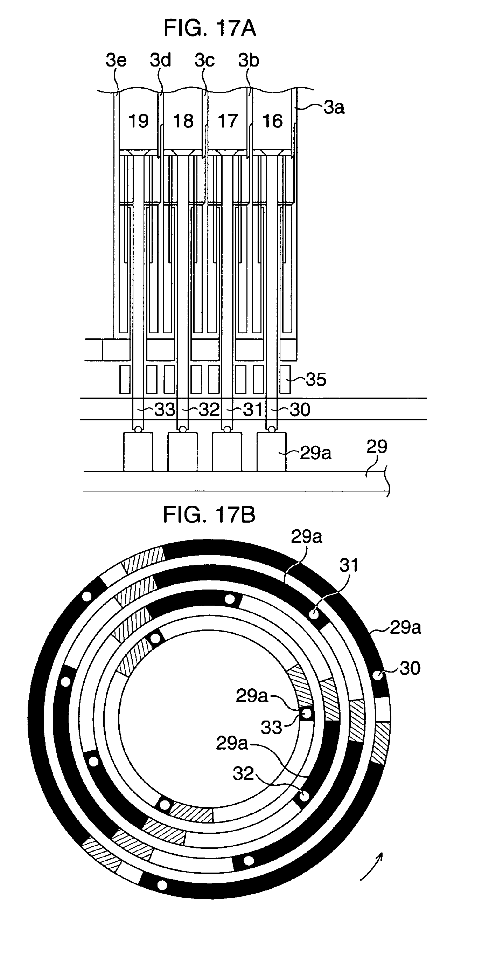

At this time, the lifting mechanism 28 rotates the fence lifting plate 29 around the axis of the fence lifting plate 29 by driving the motor 34 shown in Fig. 2. In the present embodiment, the fence lifting plate 29 is rotated by about 107° counterclockwise to the position shown in Fig. 9A. Thereby engaging the shafts 30 to 33 disposed at specific positions with the cams 29a of the fence lifting plate 29 which rotationally moved so as to drive the fences 3a to 3d connected to the shafts 30 to 33 upward as shown in Fig. 17A. The positional relation between the respective shafts 30 to 33 and the cams 29a (between regions shown in black and regions shown by diagonal lines) is as shown in Fig. 17B. As clearly shown also in Fig. 17B, all the shafts 30 to 33 engage with the cam 29a.

When a plurality types of liquid chemicals are recovered with prescribed recovery tanks, the recovery can be performed without mixing the liquid chemical into not specified other recovery tanks through the above-described treatment. Therefore, separated recovery and separated disposal can be efficiently performed. It is also possible to place the position of the substrate 11 held by the substrate chucking unit 13 above the positions of the fences 3a to 3d at the time of not performing recovery of the treatment liquid, so that carrying in and out of the substrate 11 can be smoothly performed.

Although the lifting mechanism 28 drives the fences 3a to 3d connected to the shafts 30 to 33 upward in the order of the fence 3a, the fence 3b, the fence 3c and the fence 3d upwar each independently in order to separately recover a plurality types of liquid chemicals into the respective tanks by each chemical, when the respective fences 3a to 3d which are driven upward to treat the substrate to be treated next are lowered to the original height after completing the separated recovery, the respective fences 3a to 3d are driven downward in the order of the fence 3d, the fence 3c, the fence 3b, and the fence 3a each independently. In the embodiment of the present invention, when the respective fences 3a to 3d driven upward are lowered to the original height, it is possible to adopt a method such that the fence lifting plate 29 is rotated further in a counterclockwise direction (in the same direction as the upward drive of the fence) by driving the motor 34 shown in Fig. 2 from the position shown in Fig. 17B so that the respective fences 3a to 3d are lowered to the original height, or a method such that the fence lifting plate 29 is rotated in a clockwise direction by the motor 34 (rotated into the opposite direction to the upward drive of the fence) to put the fence lifting plate back at the original position shown in Fig. 9B so that the respective fences 3a to 3d are lowered to the original height.

According to the embodiment of the present invention, when a liquid chemical used to treat the substrate 11 is recovered into a certain recovery tank, the recovery is carried out in a state of closing inlets of the other recovery tanks. Therefore, it is possible to prevent the treatment liquid to be recovered from mixing into the other recovery tanks. In the above-described manner, when treatment by an acid liquid chemical and treatment by an alkaline liquid chemical are performed for instance, it is possible to perform the substrate treatment in a continuous process by the same apparatus configuration without producing salts which form particles, by mixing of these liquid chemicals.

Furthermore, since the fence lifting plate 29 is rotated within a plane forming the cams (portions with difference in level) 29a of the fence lifting plate (in the present embodiment, around the axis of the fence lifting plate 29, because the fence lifting plate 29 is formed in a circular plate) and lifting operation of the fence is performed by engaging the cam 29a with the fence, it becomes possible to separately recover the respective various liquid chemicals by each chemical with a simple formation without making the apparatus configuration of the substrate treatment apparatus complicated. By arranging in this way, the apparatus configuration can be remarkably simplified compared with cases of performing the lifting movement of the fence using an air cylinder or using a ball screw for instance. Furthermore, as for the cams 29a, since the surfaces to hoist the respective shafts 30 to 33 connected to the respective fences 3a to 3d to the upper surface are formed in a gentle slop, and the surfaces to lower the respective shafts 30 to 33 from the upper surface are formed in a steep slop or a vertical plane, when the respective fences 3a to 3d driven upward are lowered to the original height, lowering of the respective fences 3a to 3d can be performed quickly for the case of lowering the fence lifting plate 29 by rotating it in the same direction as the upward drive of the respective fences.

By taking the above-described configuration, it is possible to provide a highly reliable substrate treatment apparatus with a simple structure, which certainly prevents respective spent treatment liquids from mixing together when these treatment liquids are recovered after respective various treatments are given to a substrate using various treatment liquids.

It should be noted that though an example of arranging four recovery tanks to separately recover respective liquid chemicals by each chemical is shown in the substrate treatment apparatus of the present embodiment, the present invention can be applied so far as plural recovery tanks are provided. Further, an example of respectively connecting three shafts to the respective fences 3a to 3d forming respective recovery tanks shown in the present invention, but the present invention is applicable no matter how many number of shafts are connected.

The number of the cams 29a engaging with respective shafts and provided on the fence lifting plate 29 is explained to be one for respective shafts in the present embodiment, but the cams 29a are designed in consideration of the area of the fence lifting plate 29, the torque of the motor required for lifting of the respective fences, the angle of the gentle slope, the heights to hoist and lower each fences, and the like, and when there is no problem in strength, torque, or the like, it is possible to make the lifting efficient by providing a plurality of cams to each fence.

When respective fences are hoisted and lowered by rotating the fence lifting plate 29 in the same direction, a cam having a gentle slope for the time of hoisting the fence and a steep slope for the time of lowering the fence is structured in the present embodiment. However, the angle of the cam for lifting the fence is optional, and a cam having the same angles for both lifting is applicable, and it is also possible as a matter of course that the cam has a steep slope for the time of hoisting and a gentle slope for the time of lowering.

### Industrial Applicability

According to the present invention, when a liquid chemical used to treat the substrate 11 is recovered into a certain recovery tank, the recovery is carried out in a state to close inlets of other recovery tanks. Therefore, it is possible to prevent the treatment liquid to be recovered from mixing into other recovery tanks. Through the above-described manner, when treatment by an acid liquid chemical and treatment by an alkaline liquid chemical are performed for instance, it is possible to perform the substrate treatment in a continuous process by the same apparatus configuration without producing salts which form particles, by the mixing of these liquid chemicals. Furthermore, since the fence lifting plate 29 is rotated within a plane forming a portion with difference in level (cam) of the fence lifting plate and lifting operation of the fence is performed by engaging the cam 29a with the fence, it becomes possible to separately recover the respective treatment liquids by each chemical with a simple formation without making the apparatus configuration of the substrate apparatus complicated.

## Claims

1. A substrate treatment apparatus, comprising:
a substrate holder holding a substrate to be treated;
a substrate rotator spinning said substrate to be treated held by said substrate holder;
a treatment liquid feeder feeding a plurality of treatment liquids on the substrate to be treated; and
a treatment liquid recovery system including a plurality of fences surrounding the circumference of said substrate to be treated held by said substrate holder, separately recovering said treatment liquids scattered from said substrate to be treated by said substrate rotator into respective recovery tanks formed by said respective fences by each chemical by lifting the respective fences, and performing the recovery in a closed state of the inlets of said other recovery tanks when said treatment liquids are recovered in one of said recovery tanks,
wherein said treatment liquid recovery system includes a fence lifting plate provided with cams lifting the fence by engaging with said respective fences and performs the lifting operation of said respective fences by rotating the fence lifting plate in a plane forming said cam of the fence lifting plate.

2. The substrate treatment apparatus according to claim 1, wherein said fence lifting plate is provided with said cam corresponding to each of said respective fences.

3. The substrate treatment apparatus according to claim 1, wherein said cam is a protrusion formed on the surface of said fence lifting plate; and
wherein the treatment liquid recovery system forms guide channels for said recovery tanks recovering said treatment liquids by rotating said fence lifting plate within a plane forming said cam of the fence lifting plate so as to hoist said fence by moving the fence onto the upper surface of said protrusion.

4. The substrate treatment apparatus according to claim 2, wherein said cam is a protrusion formed on the surface of said fence lifting plate; and
wherein the treatment liquid recovery system forms guide channels for said recovery tanks recovering said treatment liquids by rotating said fence lifting plate within a plane forming said cam of the fence lifting plate so as to hoist said fence by moving the fence onto the upper surface of said protrusion.

5. The substrate treatment apparatus according to claim 1, wherein said respective fences are arranged to be layered on each other one by one from the closest side to said substrate to be treated so as to close the inlets of said respective recovery tanks; and
wherein said treatment liquid recovery system starts recovery operation from the recovery tank at the farthest position away from said substrate to be treated.

6. The substrate treatment apparatus according to claim 2, wherein said respective fences are arranged to be layered on each other one by one from the closest side to said substrate to be treated so as to close the inlets of said respective recovery tanks; and
wherein said treatment liquid recovery system starts recovery operation from the recovery tank at the farthest position away from said substrate to be treated.

7. The substrate treatment apparatus according to claim 3, wherein said respective fences are arranged to be layered on each other one by one from the closest side to said substrate to be treated so as to close the inlets of said respective recovery tanks; and
wherein said treatment liquid recovery system starts recovery operation from the recovery tank at the farthest position away from said substrate to be treated.

8. The substrate treatment apparatus according to claim 4, wherein said respective fences are arranged to be layered on each other one by one from the closest side to said substrate to be treated so as to close the inlets of said respective recovery tanks; and
wherein said treatment liquid recovery system starts recovery operation from the recovery tank at the farthest position away from said substrate to be treated.
